# EUROPEAN PATENT SPECIFICATION

(11) **EP 4 020 550 B1**
(45) Date of publication and mention of the grant of the patent: **05.07.2023**
(21) Application number: 20890896.2
(22) Date of filing: 10.11.2020
(51) Int. Cl.: H01L 23/552, H01L 23/66, H04M 1/02, H01L 23/60

(54) **ELECTRONIC DEVICE INCLUDING CONNECTION MEMBER**
ELEKTRONISCHE VORRICHTUNG MIT EINEM VERBINDUNGSELEMENT
DISPOSITIF ÉLECTRONIQUE COMPRENANT UN ÉLÉMENT DE CONNEXION

(30) Priority: 19.11.2019 KR 20190148705
(43) Date of publication of application: 29.06.2022
(73) Proprietor: Samsung Electronics Co., Ltd., Suwon-si, Gyeonggi-do 16677 (KR)
(72) Inventor: LEE, Jaekyu, Suwon-si, Gyeonggi-do 16677 (KR); CHA, Kiwoong, Suwon-si, Gyeonggi-do 16677 (KR)
(74) Representative: Gulde & Partner
(86) International application number: PCT/KR2020/015692
(87) International publication number: WO 2021/101151

(56) References cited:
- KR-A- 20160 019 248
- KR-A- 20180 021 432
- KR-A- 20190 020 971
- US-A1- 2014 226 291
- US-A1- 2017 048 366
- US-A1- 2018 232 009

## Description

### [Technical Field]

The disclosure relates to an electronic device, in particular to an electronic device including a connection member.

### [Background Art]

With the development of electronic, information, and communication technologies, a large variety of functions have been being integrated into one electronic device. For instance, a smart phone may include functions of a sound reproducing device, an imaging device, or an electronic notebook as well as its unique communication function, and more and more various functions may be implemented in the smart phone through additional installation of applications. The use of portable electronic devices, such as smart phones, becomes commonplace regardless of age or gender, and the degree of integration of electronic devices further increases to meet the diverse needs of users.

As the use of electronic devices becomes commonplace, electronic devices may be utilized not only as communication and information devices, but also as accessories for revealing individual tastes of users. For example, various materials such as synthetic resin metal, tempered glass, or ceramic may be applied to the exterior of the electronic device to improve the exterior design. On the other hand, a larger number of electronic components may be accommodated in a space of the same size or a narrower space, and signal lines for transmitting power or various data signals between the electronic components may increase in number.

US 2017/048366 A1 discloses an electronic device that includes a housing; a printed circuit board disposed within the housing; a communication circuit disposed on the printed circuit board; at least one exterior metal frame forming at least a part of the housing, and is electrically connected with the communication circuit; a first electric path that electrically connecting the at least one exterior metal frame and the printed circuit board with each other; a support structure including a metal region and a non-metal region, and supporting the printed circuit board and/or the at least one exterior metal frame; and a second electric path disposed between the printed circuit board and the metal region of the support structure and is electrically connected with the first electric path.

### [Detailed Description of the Invention]

### [Technical Problem]

When an electrically conductive member or decoration such as a metal is disposed on the exterior of the electronic device, static electricity may be generated or accumulated in the electrically conductive member (or decoration) on the exterior, depending on the use environment. The static electricity generated or accumulated in the electrically conductive member (or decoration) may be discharged to an approaching object when a certain condition is met, for example, when another electrically conductive object approaches within a certain distance. For example, when static electricity accumulated in the electrically conductive member exceeds a predetermined voltage, the static electricity may be discharged into another object or an electronic device disposed nearby.

It may be difficult to predict the voltage or discharge conditions of the static electricity accumulated in the electrically conductive member or decoration. For example, a voltage or a discharge direction at the time of electrostatic discharge may vary according to temperature or humidity around the electronic device, relative positions of other adjacent structures or components, and electrical conductivity of other structures or components. The static electricity accumulated in the electrically conductive member or decoration disposed on the exterior of the electronic device may cause damage to various electronic components inside the electronic device. For example, when the static electricity is discharged to the inside of the electronic device, it may form electromagnetic field coupling with signal lines, thereby distorting transmitted signals or causing malfunction of an electronic components.

According to the disclosure, an electronic device capable of preventing excessive accumulation of static electricity in an electrically conductive member or decoration on an exterior is provided.

According to the disclosure, an electronic device capable of mitigating or preventing damage to electronic components or deterioration of the quality of transmission signals due to the static electricity accumulated in an electrically conductive member or decoration on an exterior is provided.

According to the disclosure, an electronic device capable of preventing internal electronic components from being damaged due to static electricity accumulated in an electrically conductive member or decoration on an exterior is provided.

### [Technical Solution]

The invention is set out in the appended set of claims. According to the disclosure, an electronic device includes an exterior member having an electrical conductivity, a circuit board including a ground conductor providing a reference potential and a conductor separated from the ground conductor, a support member including at least partially an electrically conductive material, and at least one connection member positioned on the circuit board and electrically connected to the conductor, wherein the exterior member is electrically connected to the support member through the conductor and the connection member while bypassing the ground conductor.

### [Advantageous Effects]

According to the disclosure, since an electrically conductive member or decoration on the exterior is electrically connected to a ground structure (e.g., a support member), it is possible to prevent excessive accumulation of static electricity in the electrically conductive member or decoration on the exterior.

According to the disclosure, an electrostatic discharge path between an electrically conductive member (or decoration) on the exterior and a ground structure is formed to bypass the ground (e.g., a ground conductor providing a reference potential) in a circuit board, so that an electronic device may secure a stable operating environment or a stable data signal transmission environment for various electronic components.

### [Brief Description of Drawings]

FIG. 1 is a block diagram illustrating an electronic device in a network environment according to various embodiments.
FIG. 2A is a perspective view illustrating a front surface of an electronic device according to various embodiments.
FIG. 2B is a perspective view illustrating a rear surface of the electronic device illustrated in FIG. 2A.
FIG. 3 is an exploded perspective view illustrating an electronic device according to an embodiment.
FIG. 4 is an exploded perspective view illustrating a part of an electronic device according to various embodiments of the disclosure.
FIG. 5 is a side configuration diagram for explaining an electrostatic discharge path through a connection member in an electronic device according to various embodiments of the disclosure.
FIG. 6 is a side configuration diagram for explaining an embodiment of a connection member and an electrostatic discharge path in an electronic device according to various embodiments of the disclosure.
FIG. 7A is a side configuration diagram for explaining another embodiment of a connection member and an electrostatic discharge path in an electronic device according to various embodiments of the disclosure.
FIG. 7B is a side configuration diagram for explaining further another embodiment of a connection member and an electrostatic discharge path in an electronic device according to various embodiments of the disclosure.
FIG. 7C is a side configuration diagram for explaining further another embodiment of a connection member and an electrostatic discharge path in an electronic device according to various embodiments of the disclosure.
FIG. 8 is a side configuration diagram for explaining further another embodiment of a connection member and an electrostatic discharge path in an electronic device according to various embodiments of the disclosure.
FIG. 9 is a perspective view illustrating further another embodiment of a connection member in an electronic device according to various embodiments of the disclosure.
FIG. 10 is a side configuration diagram for explaining further another embodiment of a connection member and an electrostatic discharge path in an electronic device according to various embodiments of the disclosure.
FIG. 11 is a perspective view illustrating further another embodiment of a connection member in an electronic device according to various embodiments of the disclosure.
FIG. 12 is a perspective view for explaining further another embodiment of a connection member and an electrostatic discharge path in an electronic device according to various embodiments of the disclosure.
FIG. 13 is a perspective view illustrating further another embodiment of a connection member in an electronic device according to various embodiments of the disclosure.
FIG. 14 is a plan view illustrating a first wiring layer of an electronic device according to various embodiments of the disclosure.
FIG. 15 is a plan view illustrating a second wiring layer of an electronic device according to various embodiments of the disclosure.
FIG. 16 is a plan view illustrating an auxiliary circuit board provided in a camera module of an electronic device according to various embodiments of the disclosure.
FIG. 17 is a graph for explaining a current fluctuation swing level due to electrostatic discharge in an electronic device according to various embodiments of the disclosure.

### [Mode for Carrying out the Invention]

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. Terms including an ordinal number such as 'first' or 'second' may be used to describe various elements, but the elements are not limited by the terms. The terms are used only for the purpose of distinguishing one component from another. For example, without departing from the scope of the present disclosure, a first component may be referred to as a second component, and similarly, a second component may also be referred to as a first component. The term 'and/or' includes a combination of a plurality of related described items or any of a plurality of related described items. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

In addition, relative terms described based on what is shown in the drawings, such as 'front', 'rear', 'top' or 'bottom', may be replaced with ordinal numbers such as 'first' or 'second'. For ordinal numbers such as 'first' or 'second', the order may be the mentioned order or arbitrarily determined, and may be arbitrarily changed as necessary.

Terms used in this document are only used to describe specific embodiments, and are not intended to limit the present disclosure. The singular expression includes the plural expression unless the context clearly dictates otherwise. In this document, terms such as "include" or "have" are intended to designate that a feature, number, step, operation, component, part, or combination thereof described in the specification is present, but it should be understood that this does not preclude the possibility of addition or existence of one or more other features or numbers, steps, operations, components, parts, or combinations thereof.

Unless defined otherwise, all terms used herein, including technical or scientific terms, have the same meaning as commonly understood by one of ordinary skill in the art to which the invention belongs. Terms such as those defined in commonly used dictionaries should be interpreted as having a meaning consistent with the meaning in the context of the related art, and should not be interpreted in an ideal or excessively formal meaning unless explicitly defined in this document.

In this disclosure, an electronic device may be any device having a touch panel, and the electronic device may be referred to as a terminal, a portable terminal, a mobile terminal, a communication terminal, a portable communication terminal, a portable mobile terminal, or a display device.

For example, the electronic device may be a smartphone, a mobile phone, a navigation device, a game machine, a TV, a head unit for a vehicle, a notebook computer, a laptop computer, a tablet computer, a personal multimedia player (PMP) or personal digital assistants (PDA). The electronic device may be implemented as a pocket-sized portable communication terminal having a wireless communication function. Also, the electronic device may be a flexible device or a flexible display device.

The electronic device may communicate with an external electronic device such as a server, or may perform a task by interworking with the external electronic device. For example, the electronic device may transmit an image captured by a camera and/or location information detected by a sensor unit to a server through a network. The network may include, but is not limited to, a mobile or cellular network, a local area network (LAN), a wireless local area network (WLAN), a wide area network (WAN), the Internet or a small area network (SAN).

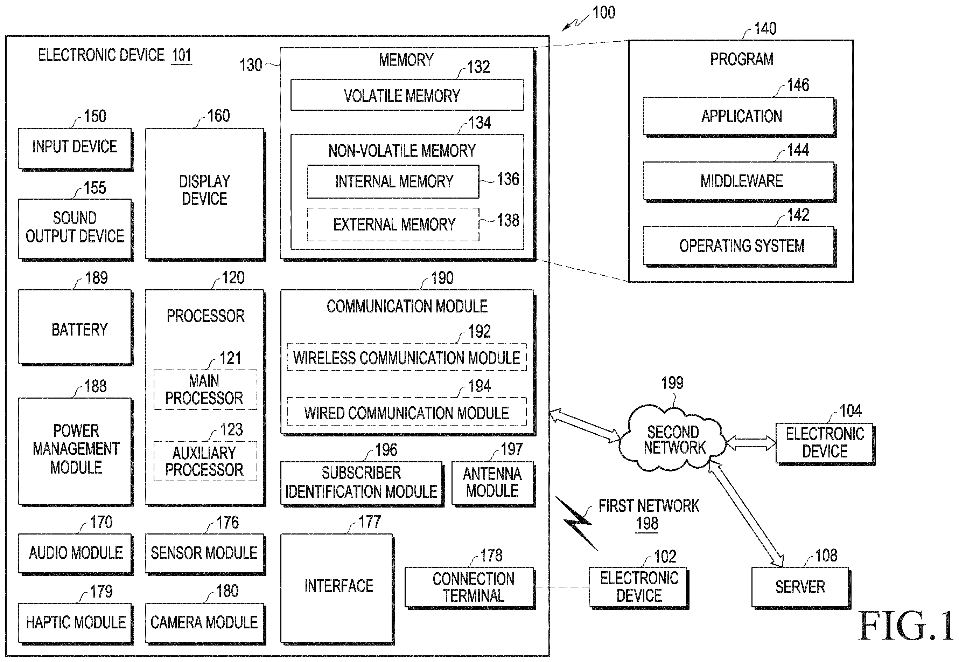

FIG. 1 is a block diagram illustrating an electronic device 1001 in a network environment 1000 according to various embodiments. Referring to FIG. 1, the electronic device 1001 in the network environment 1000 may communicate with an electronic device 1002 via a first network 1098 (e.g., a short-range wireless communication network), or an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input device 1050, a sound output device 1055, a display device 1060, an audio module 1070, a sensor module 1076, an interface 1077, a haptic module 1079, a camera module 1080, a power management module 1088, a battery 1089, a communication module 1090, a subscriber identification module (SIM) 1096, or an antenna module 1097. In some embodiments, at least one (e.g., the display device 1060 or the camera module 1080) of the components may be omitted from the electronic device 1001, or one or more other components may be added in the electronic device 1001. In some embodiments, some of the components may be implemented as single integrated circuitry. For example, the sensor module 1076 (e.g., a fingerprint sensor, an iris sensor, or an illuminance sensor) may be implemented as embedded in the display device 1060 (e.g., a display).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may load a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), and an auxiliary processor 1023 (e.g., a graphics processing unit (GPU), an image signal processor (ISP), a sensor hub processor, or a communication processor (CP)) that is operable independently from, or in conjunction with, the main processor 1021. Additionally or alternatively, the auxiliary processor 1023 may be adapted to consume less power than the main processor 1021, or to be specific to a specified function. The auxiliary processor 1023 may be implemented as separate from, or as part of the main processor 1021.

The auxiliary processor 1023 may control at least some of functions or states related to at least one component (e.g., the display device 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input device 1050 may receive a command or data to be used by other component (e.g., the processor 1020) of the electronic device 1001, from the outside (e.g., a user) of the electronic device 1001. The input device 1050 may include, for example, a microphone, a mouse, a keyboard, or a digital pen (e.g., stylus pen).

The sound output device 1055 may output sound signals to the outside of the electronic device 1001. The sound output device 1055 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 1060 may visually provide information to the outside (e.g., a user) of the electronic device 1001. The display device 1060 may include, for example, a display, a hologram device, or a projector and control circuitry to control a corresponding one of the display, hologram device, and projector. According to an embodiment, the display device 1060 may include touch circuitry adapted to detect a touch, or sensor circuitry (e.g., a pressure sensor) adapted to measure the intensity of force incurred by the touch.

The audio module 1070 may convert a sound into an electrical signal and vice versa. According to an embodiment, the audio module 1070 may obtain the sound via the input device 1050, or output the sound via the sound output device 1055 or a headphone of an external electronic device (e.g., an electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. According to an embodiment, the sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or motion) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as BluetoothTM, wireless-fidelity (Wi-Fi) direct, or infrared data association (IrDA)) or the second network 1099 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The antenna module 1097 may transmit or receive a signal or power to or from the outside (e.g., the external electronic device). According to an embodiment, the antenna module may include one antenna including a conductor formed on a substrate (e.g., a PCB) or a radiator formed of a conductive pattern. According to an embodiment, the antenna module 1097 may include one or more antennas, and, therefrom, at least one antenna appropriate for a communication scheme used in the communication network, such as the first network 1098 or the second network 1099, may be selected, for example, by the communication module 1090. The signal or the power may then be transmitted or received between the communication module 1090 and the external electronic device via the selected at least one antenna. According to some embodiments, the components (e.g., RFIC) other than the radiator may be additionally formed as a part of the antenna module 1097.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. Each of the electronic devices 1002 and 1004 may be a device of a same type as, or a different type, from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, or client-server computing technology may be used, for example.

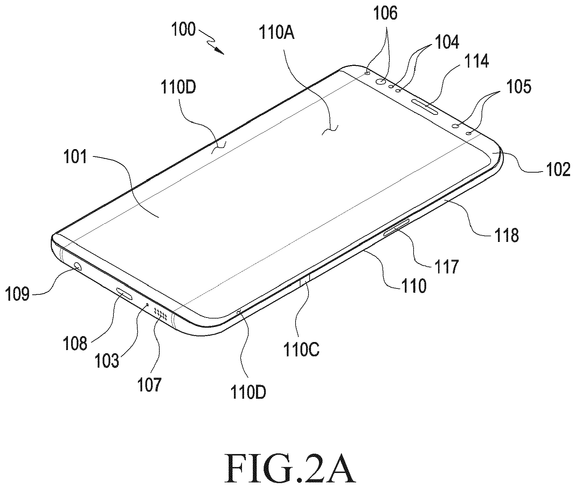

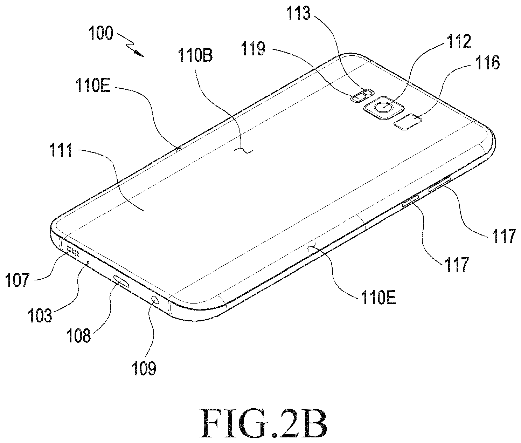

FIG. 2A is a perspective view illustrating a front surface of an electronic device 100 (e.g., an electronic device 1001 of FIG. 1) according to various embodiments. FIG. 2B is a perspective view illustrating a rear surface of the electronic device 100 illustrated in FIG. 2A.

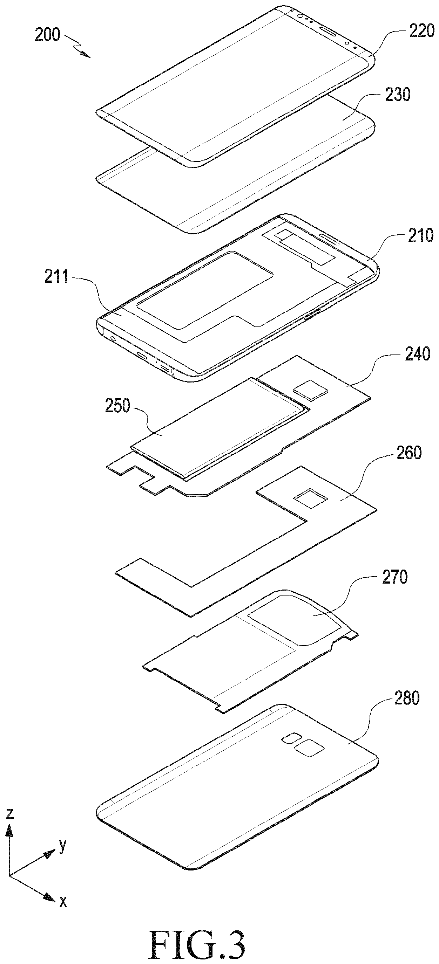

Referring to FIGS. 2A and 2B, the electronic device 100 according to an embodiment may include a housing 110 including a first surface (or front surface) 110A facing a first direction (e.g., +z direction of FIG. 3), a second surface (or a rear surface) 110B facing a second direction (e.g., -z direction of FIG. 3) opposite to the first direction, and a side surface 110C surrounding a space between the first surface 110A and the second surface 110B. In another embodiment (not shown), the housing may refer to a structure forming some of the first surface 110A of FIG. 2A, and the second surface 110B and the side surface 110C of FIG. 2B. According to one embodiment, the first surface 110A may be formed by a front plate 102 (e.g., a glass plate including various coating layers, or a polymer plate), at least a portion of which is substantially transparent. In another embodiment, the front plate 102 may be coupled to the housing 110 to form an interior space together with the housing 110. Here, the 'interior space' may refer to a space between the front plate 102 and a first support member (e.g., a first support member 211 of FIG. 3) to be described later. In various embodiments, the term 'interior space' may mean, as an internal space of the housing 110, a space accommodating at least a portion of a display 101 or a display 230 of FIG. 3, which will be described later.

According to various embodiments, the second surface 110B may be formed by a substantially opaque rear plate 111. The rear plate 111 may be formed, for example, by a coated or colored glass, ceramic, polymer, metal (e.g., aluminum, stainless steel (STS), or magnesium), or a combination of at least two of the foregoing materials. The side surface 110C may be formed by a side bezel structure (or "side member") 118 coupled to the front plate 102 and the rear plate 111 and including a metal and/or a polymer. In various embodiments, the rear plate 111 and the side bezel structure 118 may be integrally formed and may include the same material (e.g., a metal material such as aluminum).

In the illustrated embodiment, the front plate 102 may include two first areas 110D (e.g., curved areas) seamlessly bending and extending from the first surface 110A toward the rear plate 111 on both ends of the long edge of the front plate 102. In the illustrated embodiment (see FIG. 2B), the rear plate 111 may include two second areas 110E (e.g., curved areas) seamlessly bending and extending from the second surface 110B toward the front plate 102 on both ends of the long edge. In various embodiments, the front plate 102 (or the rear plate 111) may include only one of the first areas 110D (or the second areas 110E). In another embodiment, some of the first areas 110D or the second areas 110E may not be included. In embodiments, when viewed from the side of the electronic device 100, the side bezel structure 118 may have a first thickness (or width) on the side (e.g., the side in which a connector hole 108 is formed) that does not include the first areas 110D or the second areas 110E, and have a second thickness thinner than the first thickness on the side (e.g., the side on which a key input device 117 is disposed) that includes the first areas 110D or the second areas 110D.

According to an embodiment, the electronic device 100 may include at least one of a display 101 (e.g., the display device 1060 of FIG. 1), audio modules 103, 107 and 114 (e.g., the audio module 1070 of FIG. 1), sensor modules 104, 116 and 119 (e.g., sensor module 1076 in FIG. 1), camera modules 105, 112 and 113 (e.g., the camera module 1080 in FIG. 1), key input device 117, a light emitting element 106, and connector holes 108 and 109. In various embodiments, the electronic device 100 may omit at least one (e.g., the key input device 117 or the light emitting element 106) of the components or may additionally include other components.

The display 101 may be exposed through, for example, a substantial portion of the front plate 102. In various embodiments, at least a portion of the display 101 may be exposed through the front plate 102 forming the first surface 110A, and the first area 110D of the side surface 110C. In various embodiments, an edge of the display 101 may be formed to be substantially the same in shape as an adjacent outer edge of the front plate 102. In another embodiment (not shown), in order to expand the area where the display 101 is exposed, the distance between the outer periphery of the display 101 and the outer periphery of the front plate 102 may be formed to be substantially the same.

In another embodiment (not shown), a recess or opening may be formed in a portion of a screen display area (e.g., an active area) or an area outside the screen display area (e.g., an inactive area) of the display 101, and at least one of the audio module 114, the sensor module 104, the camera module 105, and the light emitting element 106 aligned with the recess or opening may be included. In another embodiment (not shown), at least one of the audio modules 103, 107 and 114, the sensor modules 104, 116 and 119, the camera modules 105, 112 and 113, the fingerprint sensor 116, and the light emitting element 106 may be included on the rear surface of the screen display area of the display 101. In another embodiment (not shown), the display 101 may be coupled to or disposed adj acent to a touch sensing circuit, a pressure sensor capable of measuring the intensity (pressure) of a touch, and/or a digitizer detecting a magnetic field type stylus pen. In some embodiments, at least some of the sensor modules 104 and 219, and/or at least a portion of the key input device 117 may be disposed in the first areas 110D and/or second areas 110E.

The audio modules 103, 107 and 114 may include a microphone hole 103 and speaker holes 107 and 114. In the microphone hole 103, a microphone for acquiring an external sound may be disposed therein, and a plurality of microphones may be disposed to detect the direction of the sound in various embodiments. The speaker holes 107 and 114 may include an external speaker hole 107 and a receiver hole 114 for a call. In various embodiments, the speaker holes 107 and 114 and the microphone hole 103 may be implemented as a single hole, or a speaker may be included without the speaker holes 107 and 114 (e.g., a piezo speaker).

The sensor modules 104, 116 and 119 may generate electrical signals or data values corresponding to an internal operating state of the electronic device 100 or an external environmental state. The sensor modules 104, 116 and 119 may include, for example, a first sensor module 104 (e.g., a proximity sensor) and/or a second sensor module (not shown) (e.g., a fingerprint sensor) disposed on the first surface 110A of the housing 110, and/or a third sensor module 119 (e.g., an HRM sensor) and/or a fourth sensor module 116 (e.g. fingerprint sensor) disposed on the second surface 110B of the housing 110 disposed on the second surface 110B of the housing 110. The fingerprint sensor may be disposed on the second surface 110B as well as the first surface 110A (e.g., the display 101) of the housing 110. The electronic device 100 may further include a sensor module (not shown), for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor or an illuminance sensor 104.

The camera modules 105, 112, and 113 may include a first camera device 105 disposed on the first surface 110A of the electronic device 100, and a second camera device 112 and/or flash 113 disposed on the second surface 110B. The camera modules 105 and 112 may include one or more lenses, an image sensor and/or an image signal processor. The flash 113 may include, for example, a light emitting diode or a xenon lamp. In various embodiments, two or more lenses (infrared cameras, wide-angle and telephoto lenses) and image sensors may be disposed on one surface of the electronic device 100.

The key input device 117 may be disposed on the side surface 110C of the housing 110. In another embodiment, the electronic device 100 may not include some or all of the above-mentioned key input devices 117, and the non-included key input devices 117 may be implemented in another form, such as a soft key, on the display 101. In various embodiments, the key input device may include a sensor module 116 disposed on the second surface 110B of the housing 110.

The light emitting element 106 may be disposed, for example, on the first surface 110A of the housing 110. The light emitting element 106 may provide, for example, state information of the electronic device 100 in the form of light. In another embodiment, the light emitting element 106 may provide, for example, a light source that is interlocked with the operation of the camera module 105. The light emitting element 106 may include, for example, an LED, an IR LED, and a xenon lamp.

The connector holes 108 and 109 may include a first connector hole 108 capable of accommodating a connector (e.g., a USB connector) for transmitting and receiving power and/or data to and from an external electronic device, and/or a second connector hole 109 (e.g., earphone jack) capable of accommodating a connector for transmitting and receiving an audio signal to and from the external electronic device.

FIG. 3 is an exploded perspective view illustrating an electronic device 200 (e.g., the electronic device 1001 of FIG. 1 or the electronic device 100 of FIGS. 2A and 2B) according to an embodiment.

Referring to FIG. 3, the electronic device 200 may include a side bezel structure 210, a first support member 211 (e.g., a bracket), a front plate 220, a display 230, and a printed circuit board 240, a battery 250, a second support member 260 (e.g., a rear case), an antenna 270, and a rear plate 280. In various embodiments, the electronic device 200 may omit at least one (e.g., the first support member 211 or the second support member 260) of the components, or may additionally include other components. At least one of the components of the electronic device 200 may be the same as or similar to at least one of the components of the electronic device 100 of FIG. 2A or 2B, and the redundant description will be omitted below.

The first support member 211 may be disposed inside the electronic device 200 and connected to the side bezel structure 210, or may be integrally formed with the side bezel structure 210. The first support member 211 may be formed of, for example, a metal material and/or a non-metallic material (e.g., polymer). The first support member 211 may have the display 230 coupled to one surface and the printed circuit board 240 coupled to the other surface. The printed circuit board 240 may be equipped with a processor (e.g., processor 1020 in FIG. 1), memory (e.g., memory 1030 in FIG. 1), and/or an interface (e.g., interface 1077 in FIG. 1). The processor may include, for example, one or more of a central processing unit, an application processor, a graphics processing unit, an image signal processor, a sensor hub processor, or a communication processor.

The display 230 (e.g., the display device 1060 of FIG. 1) may have substantially the entire area attached to the inner surface of the front plate 220, and an opaque layer may be formed near or around an area to which the display 230 is attached on the inner surface of the front plate 220. In the area of the front plate 220 where the display 230 is not disposed, the opaque layer may block a portion of the internal structure (e.g., the first support member 211) of the electronic device 200 from being exposed to the outside.

The memory (e.g., the memory 1030 of FIG. 1) may include, for example, a volatile memory or a non-volatile memory.

The interface may include, for example, a high definition multimedia interface (HDMI), a universal serial bus (USB) interface, a secure digital (SD) card interface, and/or an audio interface. The interface may, for example, electrically or physically connect the electronic device 200 to an external electronic device, and may include a USB connector, an SD card/MMC connector, or an audio connector.

The battery 250 may be a device for supplying power to at least one component of the electronic device 200 and may include, for example, a non-rechargeable primary battery, a rechargeable secondary battery, or a fuel cell. At least a portion of the battery 250 may be disposed, for example, substantially coplanar with the printed circuit board 240. The battery 250 may be integrally disposed inside the electronic device 200, or may be disposed detachably from the electronic device 200.

The antenna 270 may be disposed between the rear plate 280 and the battery 250. The antenna 270 may include, for example, a near field communication (NFC) antenna, a wireless charging antenna, and/or a magnetic secure transmission (MST) antenna. The antenna 270 may, for example, perform short-range communication with an external device or wirelessly transmit/receive power required for charging. In another embodiment, an antenna structure may be formed by some of the side bezel structure 210 and/or the first support member 211 or by a combination thereof.

Various embodiments to be considered below may include, for example, some or all of the components of the electronic devices 100 and 200 of FIGS. 2A to 3. In the following detailed description, the same reference numerals in the drawings are given or omitted for components that are the same as in the preceding embodiment or that can be easily understood through the preceding embodiment, and the detailed description thereof may also be omitted.

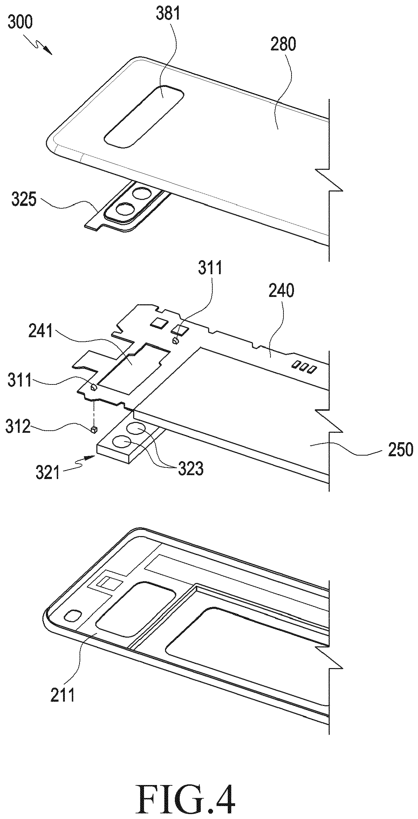

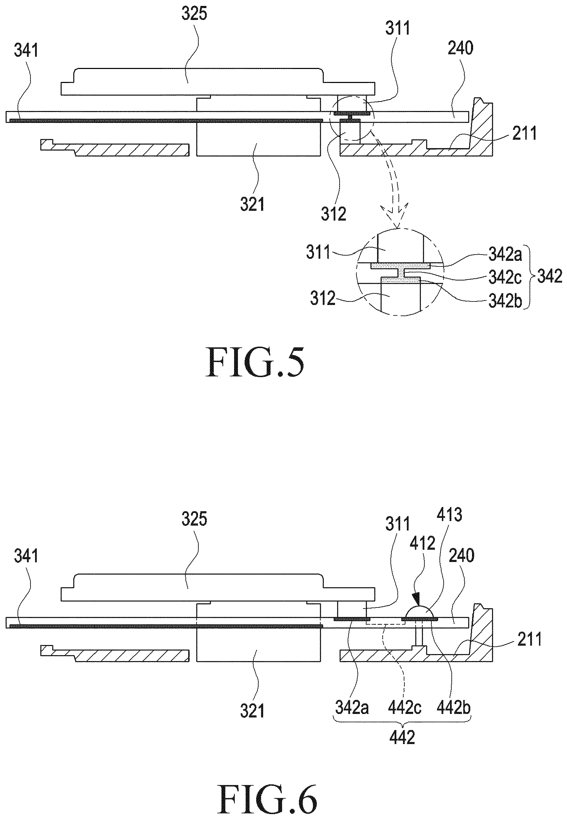

FIG. 4 is an exploded perspective view illustrating a part of an electronic device 300 (e.g., the electronic devices 100 and 200 of FIGS. 2A to 3) according to various embodiments of the disclosure. FIG. 5 is a side configuration diagram illustrating an electrostatic discharge path through connection members 311 and 312 in the electronic device 300 according to various embodiments of the disclosure.

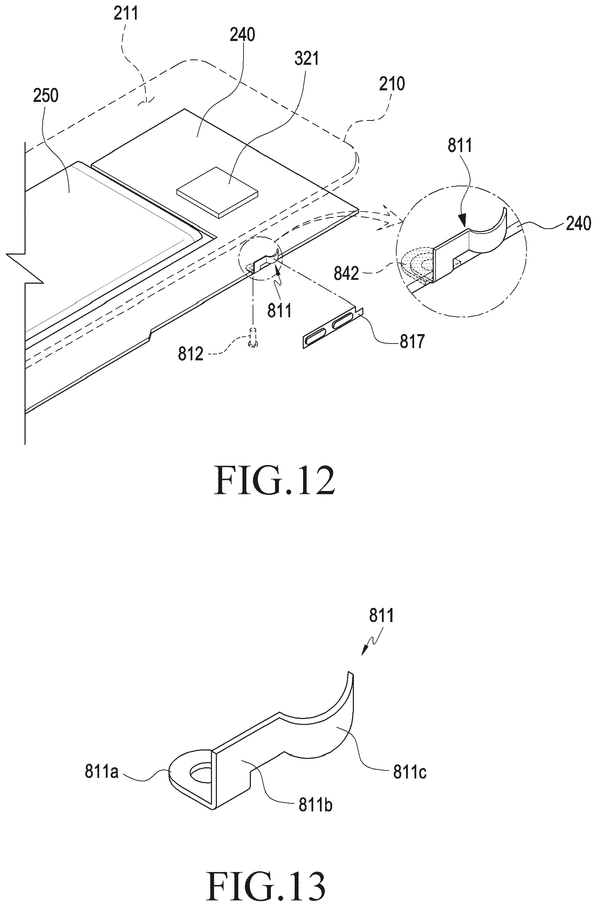

Referring to FIGS. 4 and 5, the electronic device 300 includes a support member (e.g., the first support member 211 of FIG. 3), a circuit board (e.g., the printed circuit board 240 of FIG. 3), an exterior member 325 and/or at least one connection members 311 and 312. According to the invention, the exterior member 325 is electrically connected to the support member 211 through the connection members 311 and 312 or a ground conductor (e.g., the conductor 342 of FIG. 5) provided on the circuit board 240. In some embodiments, the electronic device 300 may further include the rear plate 280, and the exterior member 325 may be disposed or mounted on the rear plate 280 to be at least partially exposed. For example, the exterior member 325 may provide a decorative effect on the exterior of the electronic device 300 and may at least partially conceal an internal electronic component such as the camera module 321. As will be seen with further reference to FIG. 12, the exterior member 325 may not be limited to the embodiment shown in FIG. 4 or FIG. 5, and may be disposed as a part of a side key (e.g., the key input device 117 of FIG. 2A or 2B) to provide a decorative effect. Although not shown, the electronic device 300 may provide a decorative effect on the exterior by including a decorative member made of another electrically conductive material, and may electrically connect the decorative member to the support member 211 by disposing additional connection members (e.g., the connection members 311 and 312).

According to various embodiments, the support member 211 may be substantially disposed inside the electronic device 300, and may be connected to or integrally formed with a structure (i.e., the side bezel structure 210 of FIG. 3) forming a side surface (e.g., the side surface 110C of FIG. 2A or 2B) of the electronic device 300. The support member 211 may be at least partially formed of a metal material. For example, the support member 211 may be at least partially electrically conductive, and when the electronic device 300 operates, the support member 211 may function as a ground by maintaining a potential lower than that of other structures or electronic components inside the electronic device 300.

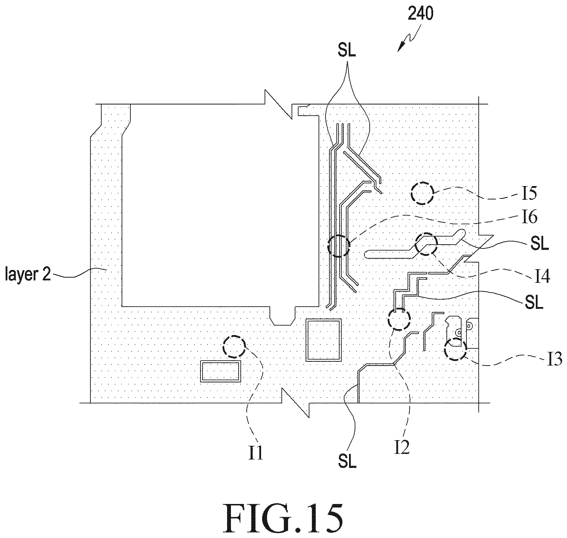

According to various embodiments, the circuit board 240 may include various signal lines (e.g., the signal line SL of FIG. 15) or electronic components (e.g., a processor, a memory and/or an interface) that are not shown, and the circuit board 240 may be coupled to any one surface of the support member 211. For example, the circuit board 240 may be positioned between the second surface (e.g., the second surface 110B of FIG. 2B or the rear plate 111 of FIG. 2B) of the housing (110 of FIG. 2A) and the support member 211. According to one embodiment, the circuit board 240 may be a multi-layered circuit board, and may include a ground conductor 341 and a conductor 342 therein. For example, the ground conductor 341 may provide a reference potential to various signal lines or electronic components within the electronic device 300. The conductor 342 may be electrically isolated from the ground conductor 341, and may function as a path for electrically connecting the exterior member 325 to the support member 211 according to an embodiment.

According to various embodiments, the conductor 342 may include a first ground pad 342a formed on one surface of the circuit board 240 and a second ground pad 342b formed on the other surface of the circuit board 240, and the second ground pad 342b may be electrically connected to the first ground pad 342a. For example, the conductor 342 may further include a via conductor 342c formed to at least partially penetrate the circuit board 240, and the second ground pad 342b may be electrically connected to the first ground pad 342a through the via conductor 342c inside the circuit board 240.

According to various embodiments, the exterior member 325 may be formed of an electrically conductive material (e.g., a metal material), and may be positioned or mounted on the second surface (e.g., second side 110B of FIG. 2B), for example, on a rear plate (the rear plate 280 of FIG. 3), of the housing (e.g., the housing 110 of FIG. 2A). For example, the circuit board 240 may be at least partially positioned between the exterior member 325 and the support member 211. According to one embodiment, the housing 110 may include an opening 381 formed through the rear plate 280, and the exterior member 325 may be positioned or mounted at least partially within the opening 381. For example, the exterior member 325 may be positioned substantially inside (e.g., a space surrounded by the side bezel structure 210 of FIG. 3) of the rear plate 280, and a portion of the exterior member 325 may be positioned in the interior space of the opening 381.

According to various embodiments, the electronic device 300 may further include a camera module 321 disposed to correspond to the opening 381 in the housing (e.g., the housing 110 of FIG. 2A). The camera module 321 may include at least one lens 323, and may acquire a subject image by detecting light incident through the opening 381. In an embodiment, the exterior member 325 may be disposed in the opening 381 to conceal at least a portion of the camera module 321 from the outside of the electronic device 300. For example, the exterior member 325 may conceal at least a portion of an electronic component or an internal structure, such as the camera module 321, inside the electronic device 300 from the outside of the electronic device 300 thereby to enhance the appearance of the electronic device 300. In an embodiment, when a portion of the circuit board 240 is disposed between the exterior member 325 and the support member 211, the circuit board 240 may further include an opening area 241. For example, the opening area 241 may be substantially aligned with the opening 381 or the exterior member 325, and the camera module 321 may be disposed in the opening area 241.

According to various embodiments, when the rear plate (for example, the rear plate 280 of FIG. 3) is made of glass, ceramic, or polymer plate instead of an electrically conductive material such as metal, the exterior member 325 may act as a medium for generating or accumulating static electricity. Static electricity accumulated in the exterior member 325 may cause an electric shock to the user, and when discharged to the inside of the electronic device 300, the static electricity may cause damage to or malfunction of internal electronic components (e.g., the camera module 321). The connection members 311 and 312 may electrically connect the exterior member 325 to the ground, for example, the support member 211, of the electronic device 300. For example, the connection members 311 and 312 discharge static electricity accumulated in the exterior member 325 to the ground, thereby preventing damage to or malfunction of electronic components inside the electronic device 300.

According to various embodiments, the connection members 311 and 312 are electrically connected to the conductor 342 to form an electrostatic discharge path bypassing the ground conductor 341. According to one embodiment, the connection members 311 and 312 may include an elastic body such as an electrically conductive gasket or a C-clip. In other embodiments, the connection members 311 and 312 may include clamping elements such as screws. For example, the connection members 311 and 312 of any one of the elastic body and the clamping element may be provided to electrically connect the exterior member 325 to the support member 211, and in another embodiment, the connection members 311 and 312 in which the elastic body and the clamping element are combined may be provided to electrically connect the exterior member 325 to the support member 211.

According to various embodiments, the connection members 311 and 312 include a first connection member 311 and a second connection member 312 disposed or mounted on the circuit board 240. The first connection member 311 may be disposed or mounted on the first ground pad 342a to be electrically connected to the exterior member 325. The first connection member 311 electrically connects the exterior member 325 to the conductor 342. The second connection member 312 may be disposed or mounted on the second ground pad 342b to be electrically connected to the support member 211. The second connection member 312 electrically connects the conductor 342 to the support member 211. In one embodiment, the first connection member 311 or the second connection member 312 may be made of an elastic body such as an electrically conductive gasket or a C-clip. In another embodiment, the first connection member 311 or the second connection member 312 may be made of an electrically conductive adhesive tape.

According to various embodiments, the exterior member 325 may be electrically connected to the support member 211 through the connection member (e.g., the first connection member 311 and/or the second connection member 312) and the conductor 342. According to an embodiment, in the electronic device 300, the exterior member 325 may be electrically connected to the support member 211 to substantially maintain a state having a potential lower than that of other structures or electronic components. Even if static electricity is generated in the exterior member 325, the static electricity is discharged to the support member 211 by bypassing the ground conductor 341 or other signal lines in the circuit board 240. For example, even if the exterior member 325 is a medium that generates or accumulates static electricity, since the exterior member 325 is electrically connected to the support member 211 having a lower potential than other structures or electronic components in the electronic device 300, the damage to or malfunction of electronic components due to the static electricity may be prevented, and the quality of a data signal transmitted within the electronic device 300 may be prevented from being deteriorated. The conductor 342 may be utilized as a path (or part of a path) for discharging static electricity from the exterior member 325 to the support member 211. Although one electrostatic discharge path (e.g., the conductor 342) is shown in this embodiment, it should be noted that the disclosure is not limited thereto. For example, as shown in FIG. 4, a plurality of first connection members 311 may be disposed on one surface of the circuit board 240, and a plurality of second connection members 312 may be provided on the other surface of the circuit board 240 to form a plurality of electrostatic discharge paths. The number and positions of the electrostatic discharge paths (e.g., the conductors 342) may vary depending on the size and shape of the exterior member 325 disposed on the actual product, which is also the same in the embodiment(s) to be described later.

Hereinafter, various embodiments of the connection members 311 and 312 will be described with reference to FIGS. 6 to 13.

FIG. 6 is a side configuration diagram for explaining an embodiment of the connection members 311 and 412 and the electrostatic discharge path in the electronic device (e.g., the electronic devices 100, 200 and 300 of FIGS. 2A to 4) according to various embodiments of the disclosure.

Referring to FIG. 6, the connection members 311 and 412 may include a first connection member 311 made of an elastic body and a second connection member 412 made of a clamping element. According to an embodiment, the conductor 442 may include a first ground pad 342a, a second ground pad 442b, and/or a ground wiring 442c disposed on one surface of the circuit board 240. The second ground pad 442b may be electrically connected to the first ground pad 342a through the ground wiring 442c provided on the circuit board 240. The first connection member 311 may be disposed or mounted on the first ground pad 342a to contact the exterior member 325. For example, the first connection member 311 may electrically connect the exterior member 325 to the conductor 442. The second connection member 412 may be a clamping element, for example, a screw, and may be coupled to the support member 211, penetrating the circuit board 240. In a state in which the second connection member 412 is bound to the support member 211, as a head 413 of the clamping element is in close contact with the second ground pad 442b on one surface of the circuit board 240, the second connection member 412 may electrically connect the conductor 442 to the support member 211. In some embodiments, the conductor 442 may consist of a single ground pad. For example, the ground wiring 442c may be omitted, and in FIG. 6, the first ground pad 342a and the second ground pad 442b may be connected to each other to be implemented as one printed circuit pattern or one conductive pad.

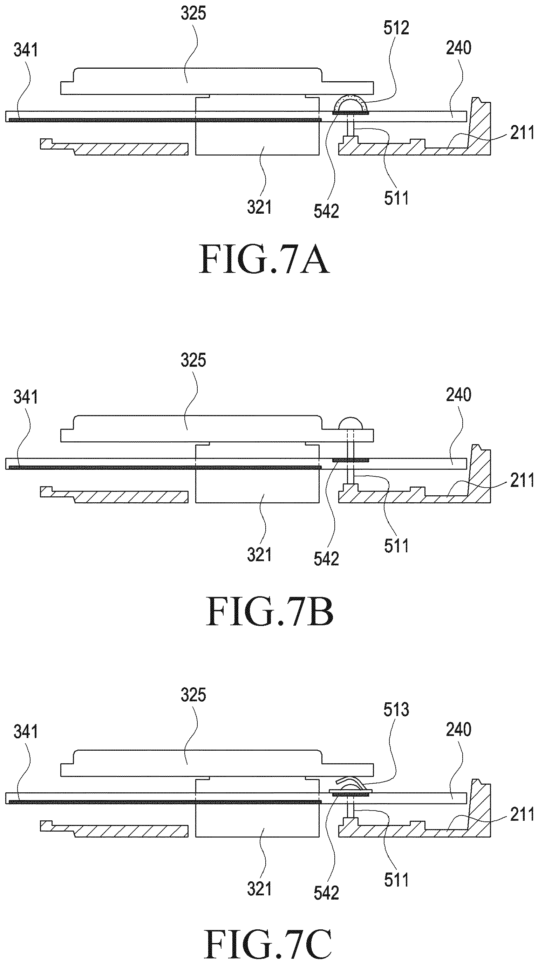

FIG. 7A is a side configuration diagram for explaining another embodiment of connection members 511 and 512 and an electrostatic discharge path in an electronic device (e.g., the electronic devices 100, 200 and 300 of FIGS. 2A to 4) according to various embodiments of the disclosure.

Referring to FIG. 7A, the connection members 511 and 512 may include a first connection member 511 made of a clamping element and a second connection member 512 made of an elastic body. According to an embodiment, the second connection member 512 may be provided to substantially surround a portion (e.g., the clamping element or the head 413 of the screw in FIG. 6) of the first connection member 511. In a structure in which the second connection member 512 surrounds a portion of the first connection member 511, the conductor 542 may be substantially made of a single ground pad provided on one surface of the circuit board 240. For example, in a state in which the first connection member 511 penetrates the circuit board 240 and is fastened to the support member 211, the first connection member 511 or the second connection member 512 may be substantially in close contact with the conductor 542. The second connection member 512 may be made of an electrically conductive gasket, a C-clip, or an electrically conductive adhesive tape to contact the exterior member 325. For example, the exterior member 325 may be electrically connected to the first connection member 511 or the conductor 542 through the second connection member 512, and the second connection member 512 or the conductor 542 may be electrically connected to the support member 211 through the first connection member 511.

FIG. 7B is a side configuration diagram for explaining further another embodiment of a connection member and an electrostatic discharge path in an electronic device according to various embodiments of the disclosure.

Referring to FIG. 7B, the connection member 511 may include one clamping element, for example, a screw. The connection member 511 may sequentially pass through the exterior member 325 and the circuit board 240 to be bound to the support member 211. In an embodiment, the connection member 511 may be electrically connected to the conductor 542 on the circuit board 240 or may be coupled to pass through the conductor 542. In another embodiment, the connection member 511 may sequentially pass through the support member 211 and the circuit board 240 to be bound to the exterior member 325.

FIG. 7C is a side configuration diagram for explaining further another embodiment of a connection member and an electrostatic discharge path in an electronic device according to various embodiments of the disclosure.

Referring to FIG. 7C, the connection member may include a first connection member 511 and a second connection member 513. The first connection member 511 may include a clamping element such as a screw, and the second connection member 513 may include, for example, a leaf spring or a C-clip. In an embodiment, the first connection member 511 may sequentially pass through the second connection member 513 and the circuit board 240 to be bound to the support member 211. For example, the second connection member 513 may be mounted on or fixed to the circuit board 240 by the first connection member 511. According to an exemplary embodiment, the connection member 511 may be electrically connected to the conductor 542 on the circuit board 240 or may be coupled to pass through the conductor 542. In one embodiment, a portion of the second connection member 513 may be disposed to protrude from the circuit board 240 to contact the exterior member 325. For example, the exterior member 325 may be electrically connected to the support member 211 through the first connection member 511 and/or the second connection member 513.

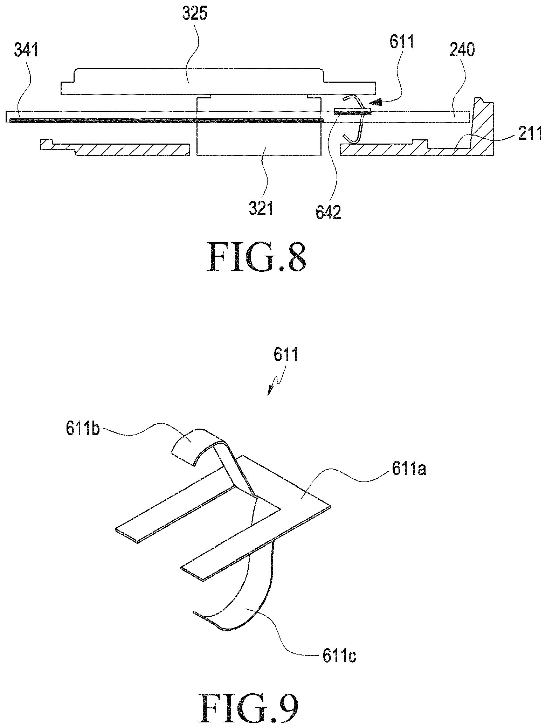

FIG. 8 is a side configuration diagram for explaining further another embodiment of a connection member 611 and an electrostatic discharge path in an electronic device (e.g., the electronic devices 100, 200 and 300 of FIGS. 2A to 4) according to various embodiments of the disclosure. FIG. 9 is a perspective view illustrating further another embodiment of a connection member 611 in an electronic device (e.g., the electronic devices 100, 200, and 300 of FIGS. 2A to 4) according to various embodiments of the disclosure.

Referring to FIGS. 8 and 9, the connection member 611 may be disposed or mounted on the circuit board 240, and a portion of the connection member 611 may be disposed to penetrate the circuit board 240. For example, a hole through which a portion of the connection member 611 is accommodated or passes may be formed in the circuit board 240. The connection member 611 may include a fixing part 611a, a first protrusion (or a first extension part) 611b, and a second protrusion (or a second extension part) 611c. In one embodiment, the fixing part 611a may have a substantially flat plate shape, and may be disposed or mounted in direct contact with one surface of the circuit board 240. A ground pad 642 (e.g., the conductor 542 of FIG. 7A) may be provided on one surface of the circuit board 240, and the fixing part 611a may be bound to the ground pad on one surface of the circuit board 240 by soldering. The first protrusion 611b may extend from the fixing part 611a to be inclined or to form a curved surface, and the second protrusion 611c may extend from the fixing part 611a to be inclined or to form a curved surface. The first protrusion 611b and the second protrusion 611c may extend substantially away from each other from the fixing part 611a, and an end of the first protrusion 611b and an end of the second protrusion 611c may extend in the direction adjacent to each other.

According to various embodiments, when the first protrusion 611b contacts the exterior member 325, the second protrusion 611c may penetrate the circuit board 240 and contact the support member 211. In another embodiment, the second protrusion 611c may be disposed to contact the exterior member 325, and the first protrusion 611b may penetrate the circuit board 240 to contact the support member 211. Unlike the state shown in FIG. 8, if the fixing part 611a is disposed or mounted on the lower surface (e.g., the surface facing the support member 211) of the circuit board 240, one of the first protrusion 611b and the second protrusions 611c may pass through the circuit board 240 to be in contact with the exterior member 325.

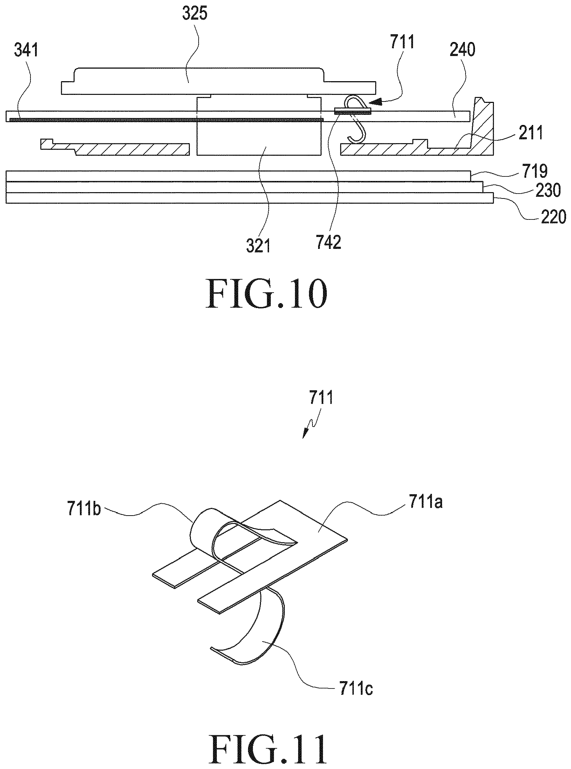

FIG. 10 is a side configuration diagram for explaining further another embodiment of a connection member 711 and an electrostatic discharge path in an electronic device (e.g., the electronic devices 100, 200 and 300 of FIGS. 2A to 4) according to various embodiments of the disclosure. FIG. 11 is a perspective view illustrating further another embodiment of the connection member 711 in the electronic device (e.g., the electronic devices 100, 200 and 300 of FIGS. 2A to 4) according to various embodiments of the disclosure.

Referring to FIGS. 10 and 11, the connection member 711 may be disposed or mounted on the circuit board 240, and a portion of the connection member 711 may be disposed to penetrate the circuit board 240. For example, the connection member 711 may include a fixing part 711a, a first protrusion (or a first extension part) 711b, and a second protrusion part (or a second extension part) 711c. In one embodiment, the fixing part 711a may have a substantially flat plate shape, and may be disposed or mounted in direct contact with one surface of the circuit board 240. A ground pad 742 (e.g., the conductor 542 of FIG. 7A) may be provided on one surface of the circuit board 240, and the fixing part 711a may be bound to the ground pad on one surface of the circuit board by soldering. The first protrusion 711b may extend from the fixing part 711a to be inclined or to form a curved surface, and the second protrusion 711c may extend from the first protrusion 711b to be inclined or to form a curved surface. For example, the connection member 711 may be configured to include an extension piece extending from the fixing part 711a. A portion of the extension piece may extend to be inclined upward of the fixing part 711a or may extend to form a curved surface to form the first protrusion part 711b, and another portion of the extension piece may extend from the first protrusion 711b to be inclined downward of the fixing part 711a or may extend to form a curved surface to form the second protrusion 711c.

According to various embodiments, when the fixing part 711a is bound to the circuit board 240, the first protrusion 711b may contact the exterior member 325, and the second protrusion 711c may penetrate the circuit board 240 and contact the support member 211. In another embodiment, unlike the state shown in FIG. 10, if the fixing part 711a is disposed or mounted on the lower surface (e.g., the surface facing the support member 211) of the circuit board 240, the first protrusion 711b may contact the support member 211, and the second protrusion 711c may be disposed to pass through the circuit board 240 to contact the exterior member 325.

According to various embodiments, the electronic device (e.g., the electronic devices 100, 200, and 300 of FIGS. 2A to 4) may include the display 230 disposed on any one surface of the support member 211 (e.g., the first support member 211 of FIG. 3). The display 230 may be disposed to face the circuit board 240 with the support member 211 interposed therebetween, and may output a screen in the direction of the front plate 220 of the electronic device, for example, in the +Z direction of FIG. 3. In one embodiment, the electronic device (e.g., the electronic device 100, 200 and 300 of FIGS. 2A to 4) may include an electromagnetic shielding sheet 719 (e.g., a copper sheet) surrounding at least a portion of the display 230. For example, the electromagnetic shielding sheet 719 may be disposed between the display 230 and the support member 211, and in some embodiments, may be defined as part of the display 230. According to an embodiment, the electromagnetic shielding sheet 719 may be electrically connected to the support member 211 to be used as a structure that provides a ground of the electronic device together with the support member 211. For example, the electromagnetic shielding sheet 719, together with the support member 211, may be utilized as a structure in which static electricity generated in or accumulated in the exterior member 325 is discharged. The static electricity generated in the exterior member 325 or accumulated in the exterior member 325 may be discharged to a free space through the support member 211 and/or the electromagnetic shielding sheet 719. According to an embodiment, the shielding sheet 719 may be manufactured by stacking a plurality of layers. The shielding sheet 719 may include a shielding film and a conductive adhesive film. According to one embodiment, the shielding film may be made of a nano-structured fiber film to shield electromagnetic waves. The fiber film may be formed thin and long by processing the fiber based on the electrospinning method. The fiber formed in this way may be formed by plating with copper (Cu), then plating with nickel (Ni), and finally plating again with copper (Cu). The fiber film may be implemented as a nanostructure formed by overlapping each of the fibers formed by the plating operation several times. The fiber film may be implemented in a nanostructure formed by overlapping the fibers formed by the plating operation several times. The shielding film may be formed to have a thickness of about 5 to 20 um (micrometer).

According to various embodiments, when the second protrusions 611c and 711c are removed from the connection members 611 and 711 of FIG. 9 or 11, the connection members 611 and 711 of FIG. 9 or 11 may be used as the first connection member 311 or the second connection member 312 of FIG. 5. In another embodiment, when the second protrusions 611c and 711c are removed from the connection members 611 and 711 of FIG. 9 or 11, the connection members 611 and 711 of FIG. 9 or 11 may be used as a connecting structure replacing the second connection member 512 of FIG. 7A.

FIG. 12 is a perspective view for explaining further another embodiment of a connection member 811 and an electrostatic discharge path in an electronic device (the electronic devices 100, 200 and 300 of FIGS. 2A to 4) according to various embodiments of the disclosure. FIG. 13 is a perspective view illustrating further another embodiment of a connection member 811 in an electronic device (e.g., the electronic devices 100, 200, and 300 of FIGS. 2A to 4) according to various embodiments of the disclosure.

Referring to FIGS. 12 and 13, an exterior member 817 may be provided as a part of a side key (e.g., the key input device 117 of FIGS. 2A and 2B), and may be exposed to the exterior of the electronic device (e.g., the electronic device 100 of FIGS. 2A and 2B). If the exterior member 817 has a structure made of an electrically conductive material, the electronic device may include the connection members 811 and 812 disposed or mounted on the circuit board 240, thereby electrically connecting the exterior member 817 to the support member (e.g., the first support member 211 of FIG. 3). According to one embodiment, the connection member may include the first connection member 811 bent to contact the exterior member 817, and the first connection member 811 may be made of an elastic body disposed or mounted on the circuit board 240. For example, the first connection member 811 may include a fixing part 811a that is in surface contact with the circuit board 240, a first extension part 811b bent perpendicular to the fixing part 811a, and a second extension part 811c extending from the first extension part 811b to form a curved surface. When the exterior member 817 is disposed or mounted in a housing (e.g., the housing 110 of FIG. 2A or 2B), the first connection member 811, e.g., the second extension part 811c, may contact the exterior member 817, thereby electrically connecting the exterior member 817 to a conductor 842 (e.g., the conductors 342, 442 and 542 of FIGS. 5 to 7A) of the circuit board 240. According to an embodiment, the connection member may further include a second connection member 812. The second connection member 812 may sequentially pass through the first connection member 811 and the circuit board 240 to be bound to the support member (e.g., the support member 211 of FIGS. 5 to 7A). For example, the exterior member 817 may be electrically connected to the support member 211 through the first connection member 811 and the second connection member 812. In one embodiment, the second connection member 812 may be replaced with the connection member 312 of FIG. 5, for example, an elastic body such as an electrically conductive gasket, a C-clip or an electrically conductive adhesive tape.

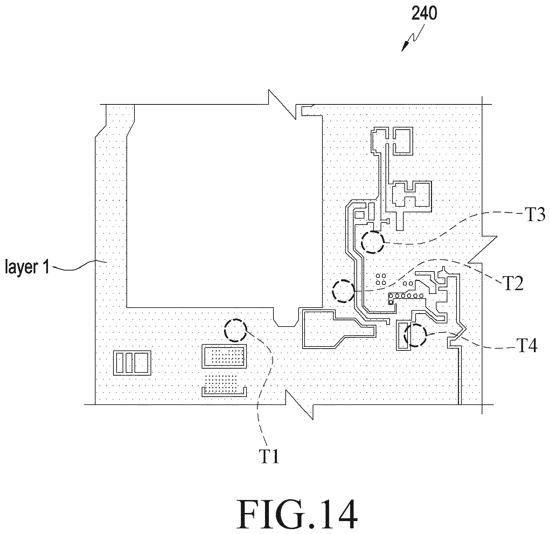

FIG. 14 is a plan view illustrating a first wiring layer (layer1) of the circuit board 240 in an electronic device according to various embodiments of the disclosure. FIG. 15 is a plan view illustrating a second wiring layer (layer2) of the circuit board 240 in an electronic device according to various embodiments of the disclosure.

FIG. 14 illustrates the first wiring layer (layer1), for example, the layer closest to the surface of the circuit board 240, for example, in the circuit board 240 with a multi-layered structure, and FIG. 15 illustrates the second wiring layer (layer2) disposed inside the circuit board 204 rather than the first wiring layer. According to an embodiment, the electronic device may include a ground (e.g., the above-described support member 211) having a lower potential than other structures or electronic components inside thereof, and a ground (e.g., the above-described ground conductor 341) providing a reference potential within the circuit board 240). In some embodiments, the exterior member (e.g., the exterior member 325 of FIG. 4) may be electrically connected to the ground conductor 341 to discharge static electricity (hereinafter, 'first discharge structure'), and in a structure in which the exterior member 325 is electrically connected to the ground conductor 341, the ground conductor 341 may be electrically connected to the support member 211. According to the invention, the exterior member 325 bypasses the ground conductor 341 and is connected to the support member to discharge static electricity (hereinafter, 'second discharge structure') (e.g., the discharge structure of FIG. 5).

[Table 1] below compares and describes the measurement results of noise levels appearing in the first wiring layer (layer1) when static electricity is discharged in the first and second discharge structures. The noise levels in [Table 1] are measured on signal lines located at four points (T1, T2, T3 and T4) of FIG. 14. In [Table 1] and [Table 2] below, 'improved width' may mean a change in the noise levels in the second discharge structure with respect to the noise levels in the first discharge structure.

**[Table 1]**

| Measurement position | First discharge structure | Second discharge structure | Improved width |
|---|---|---|---|
| T1 | 2.0 A/m | 1.2 A/m | -0.8 A/m |
| T2 | 2.7 A/m | 1.8 A/m | -0.9 A/m |
| T3 | 1.2 A/m | 0.8 A/m | -0.4 A/m |
| T4 | 0.95 A/m | 0.6 A/m | -0.35 A/m |

[Table 2] below compares and describes the measurement results of noise levels appearing in the second wiring layer (layer2) when static electricity is discharged in the first and second discharge structures. The noise levels in [Table 2] are measured on the signal lines SL positioned at the five points I1, I2, I3, I4 and 15 of FIG. 15.

**[Table 2]**

| Measurement position | First discharge structure | Second discharge structure | Improved width |
|---|---|---|---|
| I1 | 0.65 A/m | 0.2 A/m | -0.45 A/m |
| I2 | 0.8A/m | 0.5 A/m | -0.3 A/m |
| I3 | 0.7 A/m | 0.3 A/m | -0.4 A/m |
| I4 | 0.65 A/m | 0.45 A/m | -0.2 A/m |
| I5 | 0.6 A/m | 0.3 A/m | -0.3 A/m |

As described in [Table 1] and/or [Table 2] above, an electrostatic discharge structure may be provided by electrically connecting the exterior member 325 to the ground conductor 341 or the support member 211. In an embodiment, it can be seen that compared to the first discharge structure, when the electronic device includes the second discharge structure bypassing the ground conductor 341, the noise levels may be lowered and thus, better data signal transmission quality may be secured.

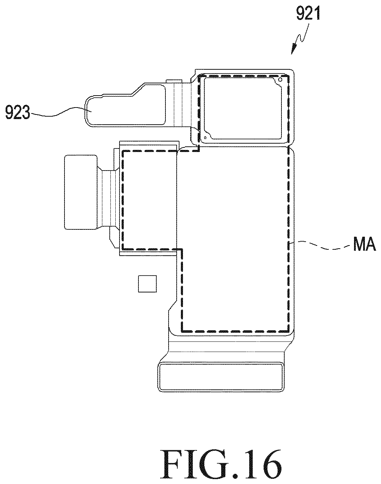

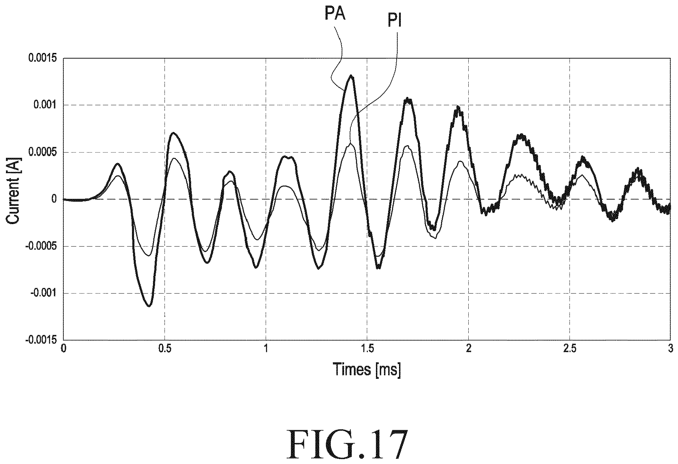

FIG. 16 is a plan view illustrating an auxiliary circuit board 921 provided to a camera module (e.g., the camera module 321 of FIG. 4) of an electronic device (e.g., the electronic devices 100, 200 and 300 of FIGS. 2A to 4) according to various embodiments of the disclosure. FIG. 17 is a graph for explaining a current fluctuation swing level due to static discharge in an electronic device (e.g., the electronic devices 100, 200, and 300 of FIGS. 2A to 4) according to various embodiments of the present disclosure.

Referring to FIG. 16, the camera module 321 may include an auxiliary circuit board (e.g., a flexible printed circuit board) 921, and may include electronic component(s) such as an image sensor, an infrared light source or a visible light source, disposed or mounted in the partial area MA. In some embodiments, the camera module 321 may further include a fingerprint sensor or bio-signal electrode disposed on the auxiliary circuit board 921. For example, although described as a 'camera module' in the above embodiment, the disclosure is not limited thereto, and among the electronic components mounted on the product, some electronic components directly exposed to the external environment or visually exposed may be integrated into the camera module 321.

According to various embodiments, the auxiliary circuit board 921 may include at least one extension part 923, and may be electrically connected to the circuit board (e.g., the printed circuit board 240 of FIG. 3) through a connector provided on the extension part 923. According to one embodiment, when the auxiliary circuit board 921 transmits and receives a data signal to and from the circuit board 240 through the extension part 923 or a connector provided on the extension part 923, noises may be generated due to electrostatic discharge. FIG. 17 is a graph showing the measurement of the current fluctuation swing level due to electrostatic discharge in the extension part 923 or the connector provided on the extension part 923. The larger the current undulation, the greater the influence of noise caused by the electrostatic discharge.

In FIG. 17, 'PA' denotes the current fluctuation swing level in the extension part 923 or the connector provided on the extension part 923, when the first discharge structure (e.g., a structure in which static electricity is discharged to the ground conductor 341 of FIG. 5 or the ground conductor 341 is included in the discharge path) is applied, and 'PI' denotes the current fluctuation swing level in the extension part 923 or the connector provided on the extension part 923, when the second discharge structure (e.g., a structure in which a discharge path is formed bypassing the ground conductor 341 of FIG. 5) is applied. As shown in FIG. 17, the first discharge structure and the second discharge structure may discharge static electricity generated in or accumulated in the exterior member 325. It can be seen that when the second discharge structure is applied, the current fluctuation swing level is lowered by up to about 50%, compared to when the first discharge structure is applied. For example, by applying the second discharge structure, data signal transmission quality between the camera module (e.g., the auxiliary circuit board 921 or the camera module 321 of FIG. 4) and the circuit board 240 may be improved.

As described above, according to various embodiments of the disclosure, an electronic device (e.g., the electronic devices 100, 200 and 300 of FIGS. 2A to 4) includes an exterior member (e.g., the exterior member 325 of FIG. 4 or 5) having an electrical conductivity, a circuit board (e.g., the circuit board 240 of FIGS. 3 to 5) including a ground conductor (e.g., the ground conductor 341 of FIG. 5) providing a reference potential and a conductor (e.g., the conductor 342 of FIG. 5) separated from the ground conductor, a support member (e.g., the support member 211 of FIGS. 3-5) including at least partially an electrically conductive material, and at least one connection member (e.g., the connection members 311, 312, 412, 511, 512, 611, 711, 811 and 812 of FIGS. 5 to 13) positioned on the circuit board and electrically connected to the conductor, and wherein the exterior member is electrically connected to the support member through the conductor and the connection member.

According to various embodiments, the circuit board may be at least partially positioned between the exterior member and the support member.

According to various embodiments, the electronic device may further include a housing (e.g., the housing 110 of FIG. 2A) including a first surface (e.g., the first surface 110A of FIG. 2A) facing a first direction, a second surface (e.g., the second 2 surface 110B of FIG. 2B) facing a second direction opposite to the first direction, and a sidewall (e.g., the sidewall 110C of FIG. 2A or 2B, or the side bezel structure 210 of FIG. 3) at least partially surrounding a space between the first surface and the second surface, wherein the exterior member may be positioned on the second surface and the circuit board may be positioned between the second surface and the support member.

According to various embodiments, the housing may include a rear plate (e.g., the rear plate 280 of FIG. 3 or 4) forming the second surface, and an opening (e.g., the opening 381 of FIG. 4) formed through the rear plate, wherein the exterior member may be positioned at least partially within the opening.

According to various embodiments, the electronic device may further include a camera module (e.g., the camera module 321 of FIG. 4 or 5) positioned in the housing to correspond to the opening, wherein the exterior member may conceal at least a portion of the camera module.

According to various embodiments, the connection member may include at least one of an electrically conductive gasket, a C-clip, an electrically conductive adhesive tape, or a clamping element.

According to various embodiments, the connection member may include a first connection member (e.g., the first connection member 311 of FIG. 5) positioned on the circuit board and electrically connecting the exterior member to the conductor, and a second connection member (e.g., the second connection member 312 of FIG. 5) positioned on the circuit board and electrically connecting the conductor to the support member.

According to various embodiments, the circuit board may be at least partially positioned between the exterior member and the support member, and the first connection member and the second connection member may be positioned on different surfaces of the circuit board.

According to various embodiments, the circuit board may be at least partially positioned between the exterior member and the support member, and a portion of the connection member may be positioned to penetrate the circuit board.

According to various embodiments, the connection member may include a fixing part (e.g., the fixing parts 611a and 711a FIG. 9 or 11) positioned on the circuit board and electrically connected to the conductor, a first protrusion (e.g., the first protrusions 611b and 711b of FIG. 9 or 11) extending from the fixing part and electrically connected to the exterior member or the support member, and a second protrusion (e.g., the second protrusions 611c and 711c of FIG. 9 or 11) extending from the fixing part or the first protrusion and electrically connected to the support member or the exterior member.

According to various embodiments, one of the first protrusion and the second protrusion may be positioned to penetrate the circuit board.

According to various embodiments, the electronic device may further include a display (e.g., the display 230 of FIG. 3 or 10) positioned on any one surface of the support member to output a screen in a direction of the first surface facing the first direction of the electronic device, and an electromagnetic shielding sheet (e.g., the electromagnetic shielding sheet 719 of FIG. 10) positioned between the support member and the display to at least partially surround the display, wherein the electromagnetic shielding sheet may be electrically connected to the support member.

According to various embodiments, the support member may be positioned between the exterior member and the display.

According to various embodiments of the disclosure, an electronic device may include a housing including a first surface facing a first direction, a second surface facing a second direction opposite to the first direction, and a sidewall at least partially surrounding a space between the first surface and the second surface, an exterior member positioned on the second surface and having an electrical conductivity, a support member accommodated in the housing and including at least partially an electrically conductive material, a ground conductor positioned between the second surface and the support member and providing a reference potential, a circuit board including a conductor separated from the ground conductor, and at least one connection member positioned on the circuit board and electrically connected to the conductor, wherein the exterior member may be electrically connected to the support member through the conductor and the connection member.

According to various embodiments, the connection member may include a first connection member positioned on the circuit board and electrically connecting the exterior member to the conductor, and a second connection member positioned on the circuit board and electrically connecting the conductor to the support member.

According to various embodiments, the circuit board may be at least partially positioned between the exterior member and the support member, and a portion of the connection member may be positioned to pass through the circuit board.

According to various embodiments, the connection member may include a fixing part positioned on the circuit board and electrically connected to the conductor, a first protrusion extending from the fixing part and electrically connected to the exterior member or the support member, and a second protrusion extending from the fixing part or the first protrusion and electrically connected to the support member or the exterior member.

According to various embodiments, the connection member may include at least one of an electrically conductive gasket, a C-clip, an electrically conductive adhesive tape, or a clamping element.

According to various embodiments, the connection member may include a clamping element penetrating the circuit board and coupled to the support member.

According to various embodiments, a structure forming the sidewall may be integrally formed with the support member.

## Claims

1. An electronic device (100, 200, 300, 1001) comprising:
an exterior member (325, 817) having an electrical conductivity;
a circuit board (204, 240) including a ground conductor (341) providing a reference potential and a conductor (342, 442, 542, 842) separated from the ground conductor (341);
a support member (211) including at least partially an electrically conductive material; and
at least one connection member (311, 312, 412, 511, 512, 611, 711, 811, 812) positioned on the circuit board (204, 240) and electrically connected to the conductor (342, 442, 542, 842),
**characterized in that** the exterior member (325, 817) is electrically connected to the support member (211) through the conductor (342, 442, 542, 842) and the connection member (311, 312, 412, 511, 512, 611, 711, 811, 812) while bypassing the ground conductor (341).

2. The electronic device (100, 200, 300, 1001) of claim 1, wherein the circuit board (204, 240) is at least partially positioned between the exterior member (325, 817) and the support member (211).

3. The electronic device (100, 200, 300, 1001) of claim 1 or 2, further comprising a housing (110) including a first surface (110A) facing a first direction, a second surface (110B) facing a second direction opposite to the first direction, and a sidewall (110C) at least partially surrounding a space between the first surface (110A) and the second surface (110B),
wherein the exterior member (325, 817) is positioned on the second surface (110B) and the circuit board (204, 240) is positioned between the second surface (110B) and the support member (211).

4. The electronic device (100, 200, 300, 1001) of claim 3, wherein the housing (110) includes a rear plate (111, 280) forming the second surface (110B), and an opening (381) formed through the rear plate (111, 280),
wherein the exterior member (325, 817) is positioned at least partially within the opening (381).

5. The electronic device (100, 200, 300, 1001) of claim 4, further comprising a camera module (105, 112, 113, 321, 1080) positioned in the housing (110) to correspond to the opening (381),
wherein the exterior member (325, 817) conceals at least a portion of the camera module (105, 112, 113, 321, 1080).

6. The electronic device (100, 200, 300, 1001) of one of the preceding claims, wherein the connection member (311, 312, 412, 511, 512, 611, 711, 811, 812) includes at least one of an electrically conductive gasket, a C-clip, an electrically conductive adhesive tape, or a clamping element.

7. The electronic device (100, 200, 300, 1001) of one of the preceding claims, wherein the connection member (311, 312, 412, 511, 512, 611, 711, 811, 812) includes:
a first connection member (311, 511, 811) positioned on the circuit board (204, 240) and electrically connecting the exterior member (325, 817) to the conductor (342, 442, 542, 842); and
a second connection member (312, 412, 512, 513, 812) positioned on the circuit board (204, 240) and electrically connecting the conductor (342, 442, 542, 842) to the support member (211).

8. The electronic device (100, 200, 300, 1001) of claim 7, wherein the circuit board (204, 240) is at least partially positioned between the exterior member (325, 817) and the support member (211), and
wherein the first connection member (311, 511, 811) and the second connection member (312, 412, 512, 513, 812) are positioned on different surfaces of the circuit board (204, 240).

9. The electronic device (100, 200, 300, 1001) of one of the preceding claims, wherein the circuit board (204, 240) is at least partially positioned between the exterior member (325, 817) and the support member (211),
wherein a portion of the connection member (311, 312, 412, 511, 512, 611, 711, 811, 812) is positioned to penetrate the circuit board (204, 240).

10. The electronic device (100, 200, 300, 1001) of claim 9, wherein the connection member (311, 312, 412, 511, 512, 611, 711, 811, 812) comprises:
a fixing part (611a, 711a, 811a) positioned on the circuit board (204, 240) and electrically connected to the conductor (342, 442, 542, 842);
a first protrusion (611b, 711b) extending from the fixing part (611a, 711a, 811a) and electrically connected to the exterior member (325, 817) or the support member; and
a second protrusion (611c, 711c) extending from the fixing part (611a, 711a, 811a) or the first protrusion (611b, 711b) and electrically connected to the support member (211) or the exterior member (325, 817).

11. The electronic device (100, 200, 300, 1001) of claim 10, wherein one of the first protrusion (611b, 711b) and the second protrusion (611c, 711c) is positioned to penetrate the circuit board (204, 240).

12. The electronic device (100, 200, 300, 1001) of one of the preceding claims, further comprising:
a display (101, 230) positioned on any one surface of the support member (211) to output a screen in a direction of a first surface (110a) facing the first direction of the electronic device (100, 200, 300, 1001); and
an electromagnetic shielding sheet (719) positioned between the support member (211) and the display (101, 230) to at least partially surround the display (101, 230),
wherein the electromagnetic shielding sheet (719) is electrically connected to the support member (211).

13. The electronic device (100, 200, 300, 1001) of claim 12, wherein the support member (211) is positioned between the exterior member (325, 817) and the display (101, 230).

14. The electronic device (100, 200, 300, 1001) of one of the preceding claims, wherein the connection member (311, 312, 412, 511, 512, 611, 711, 811, 812) includes a clamping element penetrating the circuit board (204, 240) and coupled to the support member (211).

15. The electronic device (100, 200, 300, 1001) of claim 3, wherein a structure forming the sidewall (110C) is integrally formed with the support member (211).

## Patentansprüche

1. Elektronische Vorrichtung (100, 200, 300, 1001), die Folgendes umfasst:
ein äußeres Element (325, 817), das eine elektrische Leitfähigkeit aufweist;
eine Leiterplatte (204, 240), die einen Erdleiter (341)der ein Bezugspotential bereitstellt, und einen vom Erdleiter (341) getrennten Leiter (342, 442, 542, 842) umfasst;
ein Stützelement (211), das zumindest teilweise ein elektrisch leitendes Material enthält; und
mindestens ein Verbindungselement (311, 312, 412, 511, 512, 611, 711, 811, 812), das auf der Leiterplatte (204, 240) angeordnet und elektrisch mit dem Leiter (342, 442, 542, 842) verbunden ist,
**dadurch gekennzeichnet, dass** das äußere Element (325, 817) über den Leiter (342, 442, 542, 842) und das Verbindungselement (311, 312, 412, 511, 512, 611, 711, 811, 812) unter Umgehung des Erdleiters (341) elektrisch mit dem Stützelement (211) verbunden ist.

2. Elektronische Vorrichtung (100, 200, 300, 1001) nach Anspruch 1, wobei die Leiterplatte (204, 240) zumindest teilweise zwischen dem äußeren Element (325, 817) und dem Stützelement (211) angeordnet ist.

3. Elektronische Vorrichtung (100, 200, 300, 1001) nach Anspruch 1 oder 2, die ferner ein Gehäuse (110) umfasst, das eine erste Oberfläche (110A), die in eine erste Richtung weist, eine zweite Oberfläche (110B), die in eine zweite, der ersten Richtung entgegengesetzte Richtung weist, und eine Seitenwand (110C) enthält, die einen Raum zwischen der ersten Oberfläche (110A) und der zweiten Oberfläche (110B) zumindest teilweise umgibt,
wobei das äußere Element (325, 817) auf der zweiten Oberfläche (110B) angeordnet ist und die Leiterplatte (204, 240) zwischen der zweiten Oberfläche (110B) und dem Stützelement (211) angeordnet ist.

4. Elektronische Vorrichtung (100, 200, 300, 1001) nach Anspruch 3, wobei das Gehäuse (110) eine hintere Platte (111, 280), die die zweite Oberfläche (110B) bildet, und eine durch die hintere Platte (111, 280) gebildete Öffnung (381) aufweist,
wobei das äußere Element (325, 817) zumindest teilweise innerhalb der Öffnung (381) angeordnet ist.

5. Elektronische Vorrichtung (100, 200, 300, 1001) nach Anspruch 4, ferner umfassend ein Kameramodul (105, 112, 113, 321, 1080), das im Gehäuse (110) entsprechend der Öffnung (381) angeordnet ist, wobei das äußere Element (325, 817) mindestens einen Abschnitt des Kameramoduls (105, 112, 113, 321, 1080) verdeckt.

6. Elektronische Vorrichtung (100, 200, 300, 1001) nach einem der vorhergehenden Ansprüche, wobei das Verbindungselement (311, 312, 412, 511, 512, 611, 711, 811, 812) mindestens eines von einer elektrisch leitenden Dichtung, einem C-Clip, einem elektrisch leitenden Klebeband oder einem Klemmelement umfasst.

7. Elektronische Vorrichtung (100, 200, 300, 1001) nach einem der vorhergehenden Ansprüche, wobei das Verbindungselement (311, 312, 412, 511, 512, 611, 711, 811, 812) umfasst:
ein erstes Verbindungselement (311, 511, 811), das auf der Leiterplatte (204, 240) angeordnet ist und das äußere Element (325, 817) mit dem Leiter (342, 442, 542, 842) elektrisch verbindet; und
ein zweites Verbindungselement (312, 412, 512, 513, 812), das auf der Leiterplatte (204, 240) angeordnet ist und den Leiter (342, 442, 542, 842) elektrisch mit dem Stützelement (211) verbindet.

8. Elektronische Vorrichtung (100, 200, 300, 1001) nach Anspruch 7, wobei die Leiterplatte (204, 240) zumindest teilweise zwischen dem äußeren Element (325, 817) und dem Stützelement (211) angeordnet ist, und
wobei das erste Verbindungselement (311, 511, 811) und das zweite Verbindungselement (312, 412, 512, 513, 812) auf verschiedenen Oberflächen der Leiterplatte (204, 240) angeordnet sind.

9. Elektronische Vorrichtung (100, 200, 300, 1001) nach einem der vorhergehenden Ansprüche, wobei die Leiterplatte (204, 240) zumindest teilweise zwischen dem äußeren Element (325, 817) und dem Stützelement (211) angeordnet ist,
wobei ein Abschnitt des Verbindungselements (311, 312, 412, 511, 512, 611, 711, 811, 812) so angeordnet ist, dass er die Leiterplatte (204, 240) durchdringt.

10. Elektronische Vorrichtung (100, 200, 300, 1001) nach Anspruch 9, wobei das Verbindungselement (311, 312, 412, 511, 512, 611, 711, 811, 812) umfasst:
ein Befestigungsteil (611a, 711a, 811a), das auf der Leiterplatte (204, 240) angeordnet und elektrisch mit dem Leiter (342, 442, 542, 842) verbunden ist;
einen ersten Vorsprung (611b, 711b), der sich von dem Befestigungsteil (611a, 711a, 811a) aus erstreckt und elektrisch mit dem äußeren Element (325, 817) oder dem Stützelement verbunden ist; und
einen zweiten Vorsprung (611c, 711c), der sich von dem Befestigungsteil (611a, 711a, 811a) oder dem ersten Vorsprung (611b, 711b) erstreckt und elektrisch mit dem Stützelement (211) oder dem äußeren Element (325, 817) verbunden ist.

11. Elektronische Vorrichtung (100, 200, 300, 1001) nach Anspruch 10, wobei entweder der erste Vorsprung (611b, 711b) oder der zweite Vorsprung (611c, 711c) so angeordnet ist, dass er die Leiterplatte (204, 240) durchdringt.

12. Elektronische Vorrichtung (100, 200, 300, 1001) nach einem der vorangehenden Ansprüche, ferner umfassend:
eine Anzeige (101, 230), die auf einer beliebigen Oberfläche des Stützelements (211) angeordnet ist, um einen Bildschirm in einer Richtung einer ersten Oberfläche (110a) auszugeben, die der ersten Richtung der elektronischen Vorrichtung (100, 200, 300, 1001) zugewandt ist; und
eine elektromagnetische Abschirmplatte (719), die zwischen dem Stützelement (211) und der Anzeige (101, 230) angeordnet ist, um die Anzeige (101, 230) zumindest teilweise zu umgeben,
wobei die elektromagnetische Abschirmplatte (719) elektrisch mit dem Stützelement (211) verbunden ist.

13. Elektronische Vorrichtung (100, 200, 300, 1001) nach Anspruch 12, wobei das Stützelement (211) zwischen dem äußeren Element (325, 817) und der Anzeige (101, 230) angeordnet ist.

14. Elektronische Vorrichtung (100, 200, 300, 1001) nach einem der vorhergehenden Ansprüche, wobei das Verbindungselement (311, 312, 412, 511, 512, 611, 711, 811, 812) ein Klemmelement aufweist, das die Leiterplatte (204, 240) durchdringt und mit dem Stützelement (211) verbunden ist.

15. Elektronische Vorrichtung (100, 200, 300, 1001) nach Anspruch 3, wobei eine Struktur, die die Seitenwand (110C) bildet, einstückig mit dem Stützelement (211) ausgebildet ist.

## Revendications

1. Dispositif électronique (100, 200, 300, 1001), comprenant :
un élément extérieur (325, 817) ayant une conductivité électrique ;
une carte de circuit imprimé (204, 240) comprenant un conducteur de terre (341) fournissant un potentiel de référence, et un conducteur (342, 442, 542, 842) séparé du conducteur de terre (341) ;
un élément de support (211) comprenant au moins partiellement un matériau électriquement conducteur ; et
au moins un élément de connexion (311, 312, 412, 511, 512, 611, 711, 811, 812) positionné sur la carte de circuit imprimé (204, 240) et connecté électriquement au conducteur (342, 442, 542, 842),
**caractérisé en ce que** l'élément extérieur (325, 817) est connecté électriquement à l'élément de support (211) par l'intermédiaire du conducteur (342, 442, 542, 842) et de l'élément de connexion (311, 312, 412, 511, 512, 611, 711, 811, 812) tout en contournant le conducteur de terre (341).

2. Dispositif électronique (100, 200, 300, 1001) de la revendication 1, dans lequel la carte de circuit imprimé (204, 240) est au moins partiellement positionnée entre l'élément extérieur (325, 817) et l'élément de support (211).

3. Dispositif électronique (100, 200, 300, 1001) de la revendication 1 ou 2, comprenant en outre un boîtier (110) comprenant une première surface (110A) orientée dans une première direction, une deuxième surface (110B) orientée dans une deuxième direction opposée à la première direction, et une paroi latérale (110C) entourant au moins partiellement un espace entre la première surface (110A) et la deuxième surface (110B),
dans lequel l'élément extérieur (325, 817) est positionné sur la deuxième surface (110B) et la carte de circuit imprimé (204, 240) est positionnée entre la deuxième surface (110B) et l'élément de support (211).

4. Dispositif électronique (100, 200, 300, 1001) de la revendication 3, dans lequel le boîtier (110) comprend une plaque arrière (111, 280) formant la deuxième surface (110B), et une ouverture (381) formée à travers la plaque arrière (111, 280),
dans lequel l'élément extérieur (325, 817) est positionné au moins partiellement à l'intérieur de l'ouverture (381).

5. Dispositif électronique (100, 200, 300, 1001) de la revendication 4, comprenant en outre un module de caméra (105, 112, 113, 321, 1080) positionné dans le boîtier (110) pour correspondre à l'ouverture (381),
dans lequel l'élément extérieur (325, 817) dissimule au moins une partie du module de caméra (105, 112, 113, 321, 1080).

6. Dispositif électronique (100, 200, 300, 1001) de l'une des revendications précédentes, dans lequel l'élément de connexion (311, 312, 412, 511, 512, 611, 711, 811, 812) comprend au moins l'un d'un joint électriquement conducteur, d'un clip en C, d'une bande adhésive électriquement conductrice ou d'un élément de serrage.

7. Dispositif électronique (100, 200, 300, 1001) de l'une des revendications précédentes, dans lequel l'élément de connexion (311, 312, 412, 511, 512, 611, 711, 811, 812) comprend :
un premier élément de connexion (311, 511, 811) positionné sur la carte de circuit imprimé (204, 240) et connectant électriquement l'élément extérieur (325, 817) au conducteur (342, 442, 542, 842) ; et
un deuxième élément de connexion (312, 412, 512, 513, 812) positionné sur la carte de circuit imprimé (204, 240) et connectant électriquement le conducteur (342, 442, 542, 842) à l'élément de support (211).

8. Dispositif électronique (100, 200, 300, 1001) de la revendication 7, dans lequel la carte de circuit imprimé (204, 240) est au moins partiellement positionnée entre l'élément extérieur (325, 817) et l'élément de support (211), et
dans lequel le premier élément de connexion (311, 511, 811) et le deuxième élément de connexion (312, 412, 512, 513, 812) sont positionnés sur des surfaces différentes de la carte de circuit imprimé (204, 240).

9. Dispositif électronique (100, 200, 300, 1001) de l'une des revendications précédentes, dans lequel la carte de circuit imprimé (204, 240) est au moins partiellement positionnée entre l'élément extérieur (325, 817) et l'élément de support (211),
dans lequel une partie de l'élément de connexion (311, 312, 412, 511, 512, 611, 711, 811, 812) est positionnée de manière à pénétrer dans la carte de circuit imprimé (204, 240).

10. Dispositif électronique (100, 200, 300, 1001) de la revendication 9, dans lequel l'élément de connexion (311, 312, 412, 511, 512, 611, 711, 811, 812) comprend :
une partie de fixation (611a, 711a, 811a) placée sur la carte de circuit imprimé (204, 240) et connectée électriquement au conducteur (342, 442, 542, 842) ;
une première saillie (611b, 711b) s'étendant à partir de la partie de fixation (611a, 711a, 811a) et connectée électriquement à l'élément extérieur (325, 817) ou à l'élément de support ; et
une deuxième saillie (611c, 711c) s'étendant à partir de la partie de fixation (611a, 711a, 811a) ou de la première saillie (611b, 711b) et connectée électriquement à l'élément de support (211) ou à l'élément extérieur (325, 817).

11. Dispositif électronique (100, 200, 300, 1001) de la revendication 10, dans lequel l'une de la première saillie (611b, 711b) et de la deuxième saillie (611c, 711c) sont positionnées pour pénétrer dans la carte de circuit imprimé (204, 240).

12. Dispositif électronique (100, 200, 300, 1001) de l'une des revendications précédentes, comprenant en outre :
un affichage (101, 230) positionné sur l'une des surfaces de l'élément de support (211) pour afficher un écran dans la direction d'une première surface (1 10a) orientée vers la première direction du dispositif électronique (100, 200, 300, 1001) ; et
une feuille de protection électromagnétique (719) placée entre l'élément de support (211) et l'affichage (101, 230) pour entourer au moins partiellement l'affichage (101, 230),
dans lequel la feuille de protection électromagnétique (719) est connectée électriquement à l'élément de support (211).

13. Dispositif électronique (100, 200, 300, 1001) de la revendication 12, dans lequel l'élément de support (211) est positionné entre l'élément extérieur (325, 817) et l'affichage (101, 230).

14. Dispositif électronique (100, 200, 300, 1001) de l'une des revendications précédentes, dans lequel l'élément de connexion (311, 312, 412, 511, 512, 611, 711, 811, 812) comprend un élément de serrage pénétrant dans la carte de circuit imprimé (204, 240) et couplé à l'élément de support (211).

15. Dispositif électronique (100, 200, 300, 1001) de la revendication 3, dans lequel une structure formant la paroi latérale (110C) est formée intégralement avec l'élément de support (211).
